# EUROPÄISCHE PATENTSCHRIFT

(11) **EP 3 977 826 B1**
(45) Veröffentlichungstag und Bekanntmachung des Hinweises auf die Patenterteilung: **19.11.2025**
(21) Anmeldenummer: 20727258.4
(22) Anmeldetag: 19.05.2020
(51) Int. Cl.: H05K 7/14, H05K 9/00, H01F 17/06, H01F 27/06, H02M 7/00

(54) **VORRICHTUNG MIT EINER STROMSCHIENENANORDNUNG, EINER FILTERVORRICHTUNG UND EINER ABDECKUNG, ZUGEHÖRIGES HERSTELLUNGSVERFAHREN SOWIE STROMRICHTER UND ANTRIEBSEINRICHTUNG**
DEVICE HAVING A BUS BAR ASSEMBLY, A FILTER DEVICE AND A COVER, ASSOCIATED PRODUCTION METHOD, AND POWER CONVERTER AND DRIVE APPARATUS
DISPOSITIF COMPRENANT UN DISPOSITIF À BARRES CONDUCTRICES, UN DISPOSITIF DE FILTRAGE ET UN COUVERCLE, PROCÉDÉ DE FABRICATION CORRESPONDANT AINSI QUE CONVERTISSEUR DE COURANT ET DISPOSITIF D'ENTRAÎNEMENT

(30) Priorität: 29.05.2019 DE 102019114522
(43) Veröffentlichungstag der Anmeldung: 06.04.2022
(73) Patentinhaber: Valeo eAutomotive Germany GmbH, 91056 Erlangen (DE)
(72) Erfinder: HOYLER, Christoph, 91241 Kirchensittenbach (DE); KOURGIALIS, Alexandros, 95195 Röslau (DE); KAISER, Anna, 90402 Nürnberg (DE); ALEXANDRU, Andrei, 90768 Fürth (DE); NOBEL, Michael, 90425 Nürnberg (DE); TILP, Michael, 90402 Nürnberg (DE); BEER, Alexander, 90489 Nürnberg (DE)
(74) Vertreter: Valeo Powertrain Systems
(86) Internationale Anmeldenummer: PCT/EP2020/063945
(87) Internationale Veröffentlichungsnummer: WO 2020/239535

(56) Entgegenhaltungen:
- DE-A1- 102015 205 815
- JP-A- 2014 017 449
- US-A1- 2017 149 348
- US-A1- 2018 090 257

## Beschreibung

Die vorliegende Erfindung betrifft eine Vorrichtung mit einer zwei Stromschienen aufweisenden Stromschienenanordnung und einer Filteranordnung, umfassend eine Filtervorrichtung, welche die Stromschienen in einem Filterabschnitt umgibt, und eine die Filtervorrichtung abdeckende Abdeckung.

Daneben betrifft die Erfindung ein zugehöriges Herstellungsverfahren, einen Stromrichter und eine Antriebseinrichtung.

Filtervorrichtungen, die Stromschienen einer Stromschienenanordnung umgeben, dienen typischerweise als Mantelwellenfilter zur Verbesserung der elektromagnetischen Verträglichkeit. Eine Filtervorrichtung ist dabei typischerweise die größte und massivste Komponente, die an der Stromschienenanordnung angebracht wird. Außerdem weisen aus einem Ferritmaterial gebildete Filtervorrichtungen erhebliche Fertigungstoleranzen aufweisen, die bei der Anordnung und Fixierung an der Stromschienenanordnung zu berücksichtigen sind.

Aus dem Dokument US 2018/090257 A1 ist eine Busbar-Einheit und ein Verfahren zu ihrer Herstellung bekannt. Dabei handelt es sich um eine Konstruktion, bei der mehrere parallel verlaufende Stromschienen durch einen magnetischen Kern geführt werden, der von einem isolierenden Material umgeben ist. Der Kern dient zur Reduktion elektromagnetischer Störungen. Die Stromschienen werden innerhalb des Kerns durch isolierende Partitionen voneinander getrennt. Ziel der Erfindung ist es, die Herstellung der Einheit zu vereinfachen und ihre Größe zu reduzieren, indem der Kern und die Stromschienen getrennt montiert werden. Wesentliche Merkmale umfassen die Integration eines magnetischen Kerns, die elektrische Isolierung der Stromschienen und Methoden zur stabilen Verbindung zwischen den Komponenten.

Die Herstellung einer solchen Busbar-Einheit erfordert jedoch komplexe Formen und Verfahren, insbesondere wenn der magnetische Kern und die Stromschienen in einem Stück verbunden werden. Dies führt zu erhöhtem Produktionsaufwand und Kosten.

Das Dokument US 2017/149348 A1 beschreibt eine Geräuschfiltervorrichtung, die ebenfalls eine Busbar um einen magnetischen Kern integriert. Der magnetische Kern, der elektromagnetisches Rauschen reduziert, wird durch eine Fixiervorrichtung an der Busbar befestigt. Diese Fixiervorrichtung ermöglicht die mechanische Stabilität des Kerns und eine einfache Montage und Demontage. Der magnetische Kern kann in verschiedenen Formen ausgeführt sein, wie beispielsweise oval oder polygonal.

Die beschriebene Fixiervorrichtung für den magnetischen Kern bietet allerdings keine Optimierungsmöglichkeiten für alternative Anordnungen der Filtervorrichtung oder Anpassungen an unterschiedliche Stromschienenkonfigurationen.

Aus dem Dokument DE 10 2015 205 815 A1 ist eine Mantelwellenfiltervorrichtung in einem Elektro-/Elektrohybridfahrzeug bekannt, die zwei elektrischen Leitern einer Zuleitung zwischen einer Kraftfahrzeugbatterie und einem Umrichter zugeordnet ist. Die Mantelwellenfiltervorrichtung umfasst eine Fixiervorrichtung und einen zweiteiligen Mantelwellenfilter, der zwei Mantelwellenfilterteile umfasst, die jeweils in einer Kontaktoberfläche eine Ausnehmung zur formschlüssigen Aufnahme eines Teilabschnitts des im Betrieb stromführenden Leiters aufweisen. Die Mantelwellenfilterteile sind durch Verbinden ihrer Kontaktoberflächen zu einer die elektrischen Leiter umschließenden Einheit zusammengefügt. Als Fixiervorrichtung fungiert ein Gehäuse mit einem ersten und einem zweiten Gehäuseteil, die rastend miteinander verbindbar sind. Die Fixiervorrichtung weist ferner Federelemente zur Fixierung des Mantelwellenfilters im Innern des Gehäuses auf. Die Mantelwellenfiltervorrichtung ist formschlüssig in einer Ausnehmung in einem Gehäuse des Umrichters aufgenommen, die mit einem Deckel verschließbar ist.

Eine solche Befestigung ist jedoch nachteilig, weil die formschlüssig aufgenommene Mantelwellenfiltervorrichtung unerwünschte mechanische Lasten auf den Deckel ausübt. Die Federelemente verursachen außerdem einen Abrieb des Mantelfilters, der sich im Gehäuse des Umrichters absetzen und zu Störungen führen kann.

Der Erfindung liegt die Aufgabe zugrunde, eine demgegenüber verbesserte Möglichkeit zur Anordnung einer Filtervorrichtung an einer Stromschienenanordnung anzugeben.

Zur Lösung dieser Aufgabe wird eine Vorrichtung, wie in Anspruch 1 definiert, vorgeschlagen.

Die Erfindung beruht auf der Überlegung, eine formschlüssige Verbindung der Abdeckung und der Stromschienenanordnung zu ermöglichen, um die Filtervorrichtung an der Stromschienenanordnung zu fixieren. Dabei wird die Abdeckung selbst durch die Fixiervorrichtung an der Stromschienenanordnung angeordnet und dient nicht nur, wie herkömmlicherweise vorgesehen, der Einhausung der Filtervorrichtung. Auf diese Weise wird eine Bewegbarkeit der Abdeckung und der Filtervorrichtung in eine Richtung gehemmt, wenn die Fixiervorrichtung an der Stromschienenanordnung anliegt. Ein herkömmlicherweise vorgesehener Deckel, der diese Bewegung hemmt und eine mechanische Last aufnehmen muss, kann so vorteilhafterweise entfallen.

Die Stromschienen verlaufen entlang des Filterabschnitts typischerweise parallel. Hinsichtlich der Filtervorrichtung ist es zweckmäßig, wenn diese aus einem Ferritmaterial gebildet ist. Typischerweise ist die Filtervorrichtung aus zwei E-förmigen Körpern gebildet, deren äußere Schenkel aneinander befestigt sind. Zwischen den Schenkeln kann jeweils eine Klebeschicht zur Befestigung ausgebildet sein.

Die Fixiervorrichtung weist mehrere Fixierelemente auf, welche beim Aufsetzen der Abdeckung elastisch verformbar sind, um die Stromschienenanordnung durch Einschnappen zu hintergreifen. Eine solche Abdeckung kann einfach, beispielsweise als Spritzgussteil, gefertigt werden und lässt sich aufwandsarm durch Aufsetzen an der Stromschienenanordnung anbringen. Insbesondere ermöglicht die Schnappverbindung eine automatisierte Bestückung der Stromschienenanordnung im Rahmen der Herstellung der Vorrichtung. Typischerweise umfasst ein jeweiliges Fixierelemente einen elastisch verformbaren Schenkelabschnitt und ein an einem freien Ende des Schenkelabschnitts angeordnetes, die Stromschienenanordnung hintergreifendes Hakenelement.

Mit Vorteil kann ferner vorgesehen sein, dass die Stromschienenanordnung an beiden Enden des Filterabschnitts jeweils einen elektrisch isolierenden Steg aufweist, welchen die Fixiervorrichtung hintergreift. Besonders bevorzugt hintergreift die Fixiervorrichtung die Stege jeweils von einer der Filtervorrichtung abgewandten Seite aus. So kann auch eine Bewegbarkeit der Filtervorrichtung entlang der Erstreckungsrichtung der Stromschienen gehemmt werden.

Es kann vorgesehen sein, dass die Stromschienen jeweils im Querschnitt Langseiten und Kurzseiten aufweisen, wobei sich der Steg senkrecht zu einer jeweiligen inneren Langseite der Stromschienen erstreckt. Der Steg ist also zweckmäßigerweise zwischen den Stromschienen angeordnet.

Alternativ oder zusätzlich kann vorgesehen sein, dass der Steg im Querschnitt Langseiten und Kurzseiten aufweist, wobei sich die Kurzseiten entlang einer Richtung von einem Ende des Filterabschnitts zum anderen Ende des Filterabschnitts erstrecken.

Grundsätzlich kann bei der erfindungsgemäßen Vorrichtung vorgesehen sein, dass die Stromschienenanordnung zumindest entlang des Filterabschnitts eine die Stromschienen umgebende elektrisch isolierende Ummantelung aufweist. Die Ummantelung kann sich auch über weitere Bereiche der Stromschienen erstrecken und dort insbesondere eine oder mehrere, die Stromschienen freilegende Ausnehmungen aufweisen.

Es ist von besonderem Vorteil, wenn der Steg und die Ummantelung einstückig und/oder materialeinheitlich ausgebildet sind. So lassen sich die Stege ohne besondere Aufwände bei einem Umspritzen der Stromschienen zur Realisierung der Umwandlung ausbilden.

Die erfindungsgemäße Vorrichtung weist insbesondere auch ein Bodenelement auf, an dem die Stromschienenanordnung befestigt ist. Das Bodenelement kann beispielsweise Teil eines Gehäuses sein, welches die Stromschienenanordnung und die Filtervorrichtung aufnimmt. Besonders bevorzugt weist die Ummantelung dabei Befestigungselemente auf, durch welche die Stromschienenanordnung am Bodenelement befestigbar ist. Die Befestigungselemente können beispielsweise Vorsprünge der Ummantelung sein, in denen eine Durchgangsöffnung, und insbesondere eine darin angeordneten Einpressbuchse, ausgebildet ist. Insofern kann die Vorrichtung auch für jedes Befestigungselement ein Befestigungsmittel aufweisen, durch welches das Befestigungselement am Bodenelement befestigt ist. Im einfachsten Fall kann das Befestigungsmittel als eine die Durchgangsöffnung durchsetzende Schraube ausgebildet sein.

Um die Fixiervorrichtung in einer auf der Stromschienenanordnung aufliegenden Stellung zu fixieren kann vorgesehen sein, dass die Filteranordnung ein zwischen dem Bodenelement und der Abdeckung angeordnetes erstes Rückstellmittel aufweist, welches eine die Fixiervorrichtung an die Stromschienenanordnung pressende Rückstellkraft auf die Abdeckung ausübt. So kann eine Bewegbarkeit der Abdeckung in der Richtung senkrecht zum Bodenelement effektiv unterdrückt werden.

Besonders bevorzugt sind eine Haftreibungzahl einer abdeckungsseitigen Oberfläche des ersten Rückstellmittels bezüglich des Materials der Abdeckung und eine Haftreibungszahl einer bodenelementseitigen Oberfläche des ersten Rückstellmittels bezüglich des Materials des Bodenelements größer als eine Haftreibungszahl bezüglich des Materials der Abdeckung und des Materials des Bodenelements. So wird ein Verrutschen der Abdeckung auf dem Bodenelement verhindert.

Mit besonderem Vorteil kann die Filteranordnung ein zweites Rückstellmittel zwischen dem Bodenelement und einer Deckelfläche der Abdeckung aufweisen, wobei das zweite Rückstellmittel eine Rückstellkraft auf die Filtervorrichtung ausübt. Das zweite Rückstellmittel verhindert mithin eine Relativbewegung der Filtervorrichtung bezüglich der Abdeckung in die Richtung senkrecht zum Bodenelement. Dabei ist es bevorzugt, dass das zweite Rückstellmittel zwischen dem Bodenelement und der Filtervorrichtung vorgesehen ist. Es ist aber alternativ auch denkbar, dass das zweite Rückstellelement zwischen der Filtervorrichtung und der Deckelfläche vorgesehen ist.

Auch hinsichtlich des zweiten Rückstellmittels wird es bevorzugt, wenn eine Haftreibungzahl einer filtervorrichtungsseitigen Oberfläche des zweiten Rückstellmittels bezüglich des Materials der Filtervorrichtung und eine Haftreibungszahl einer bodenelement- oder deckelflächenseitigen Oberfläche des zweiten Rückstellmittels bezüglich des Materials des Bodenelements oder der Deckelfläche größer als eine Haftreibungszahl bezüglich des Materials der Filtervorrichtung und des Materials des Bodenelements oder der Deckelfläche sind. So wird ein Verrutschen der Filtervorrichtung gegenüber dem Bodenelement bzw. der Deckelfläche vermieden.

Besonders bevorzugt sind das erste Rückstellmittel und das zweite Rückstellmittel durch ein einteiliges Rückstellelement ausgebildet, das zwischen der Filtervorrichtung und der Abdeckung einerseits und dem Bodenelement andererseits angeordnet ist.

Mit besonderem Vorteil kann vorgesehen sein, dass das erste Rückstellmittel und/oder das zweite Rückstellmittel und/oder das Rückstellelement als flacher Formkörper ausgebildet ist oder sind. Dabei ist der das zweite Rückstellmittel bzw. das Rückstellelement ausbildende Formkörper bevorzugt plattenartig.

Ferner können das erste Rückstellmittel und/oder das zweite Rückstellmittel und/oder das Rückstellelement aus einem aufgeschäumten Material gebildet sein. Durch ein derartiges Rückstellmittel bzw. ein derartiges Rückstellelement wird im Vergleich zu auf der Filtervorrichtung aufliegenden Federelementen, wie sie nach dem Stand der Technik bekannt sind, ein Abrieb des Materials der Filtervorrichtung vermieden.

Bei der erfindungsgemäßen Vorrichtung können selbstverständlich auch ein oder mehrere weitere Filterabschnitte vorgesehen sein, wobei für den oder einen jeweiligen weiteren Filterabschnitt eine weitere Filteranordnung vorgesehen. Sämtliche Ausführungen zur zuvor beschrieben ersten Filteranordnung lassen sich dabei auf die weitere Filteranordnung oder die weiteren Filteranordnungen übertragen.

Daneben wird die der Erfindung zu Grunde liegende Aufgabe gelöst durch ein Herstellungsverfahren, umfassend folgende Schritte: Bereitstellen einer Stromschienenanordnung mit zwei Stromschienen; Anbringen einer Filtervorrichtung in einem Filterabschnitt der Stromschienenanordnung, so dass die Filtervorrichtung die Stromschienen umgibt; Bereitstellen einer Abdeckung für die Filtervorrichtung; und Fixieren der Abdeckung an der Stromschienenanordnung derart, eine Fixiervorrichtung der Abdeckung die Stromschienenanordnung hintergreift. Sämtliche Ausführungen zur erfindungsgemäßen Vorrichtung lassen sich auf das erfindungsgemäße Herstellungsverfahren übertragen, insbesondere können die zuvor beschriebenen Komponenten der Vorrichtung im Rahmen des Herstellungsverfahrens verwendet werden.

Das erfindungsgemäße Verfahren kann ferner folgenden Schritt umfassen: Bereitstellen von zwei E-förmigen Körpern, insbesondere aus einem Ferritmaterial. Dabei können die Körper zum Anbringen der Filtervorrichtung von gegenüberliegenden Seiten auf die Stromschienenanordnung und an ihren äußeren Schenkeln verklebt werden.

Es kann ferner ein Bodenelement bereitgestellte werden. Ferner kann ein erstes Rückstellmittel und/oder ein zweites Rückstellmittel bereitgestellt gestellt werden. Das oder die Rückstellmittel können auf dem Bodenelement angeordnet werden. Außerdem kann die Stromschienenanordnung derart auf dem Bodenelement angeordnet werden, dass die Filtervorrichtung auf dem zweiten Rückstellmittel aufliegt. Die Stromschienenanordnung kann am Bodenelement befestigt werden.

Bevorzugt verformen sich Fixierelemente der Abdeckung elastisch beim Fixieren und hintergreifen die Stromschienenanordnung durch Einschnappen. Ferner kann die Abdeckung das erste Rückstellmittel elastisch verformen, sodass dieses eine Rückstellkraft auf die Abdeckung ausübt. Ebenso kann beim Fixieren der Abdeckung das zweite Rückstellmittel elastisch verformt werden und eine Rückstellkraft auf die Filtervorrichtung ausüben.

Die der Erfindung zu Grunde liegende Aufgabe wird außerdem gelöst durch einen Stromrichter, umfassend die erfindungsgemäße Vorrichtung oder eine durch das erfindungsgemäße Herstellungsverfahren erhaltene Vorrichtung, wobei die Stromschienen elektrisch leitend mit einer Leistungseinheit des Stromrichters verbunden sind.

Daneben wird die der Erfindung zu Grunde liegende Aufgabe durch eine Antriebseinrichtung zum Antreiben eines Fahrzeugs gelöst, umfassend einen erfindungsgemäßen Stromrichter und eine durch den Stromrichter versorgbare elektrische Maschine.

Sämtliche Ausführungen zur erfindungsgemäßen Vorrichtung lassen sich analog auf den erfindungsgemäßen Stromrichter und die erfindungsgemäße Antriebseinrichtung übertragen, so dass die zuvor erwähnten Vorteile auch mit diesen erreicht werden können.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine perspektivische Schnittdarstellung eines Ausführungsbeispiels der erfindungsgemäßen Vorrichtung;
- Fig. 2: eine perspektivische Schnittdarstellung der in Fig. 1 gezeigten Vorrichtung in einem Filterabschnitt einer Stromschienenanordnung;
- Fig. 3: eine Draufsicht auf die Stromschienenanordnung der in Fig. 1 gezeigten Vorrichtung;
- Fig. 4: eine Prinzipskizze einer Filtervorrichtung der in Fig. 1 gezeigten Vorrichtung; und
- Fig. 5: eine Prinzipskizze eines Ausführungsbeispiels der erfindungsgemäßen Antriebseinrichtung mit einem Ausführungsbeispiel des erfindungsgemäßen Stromrichters in einem Fahrzeug.

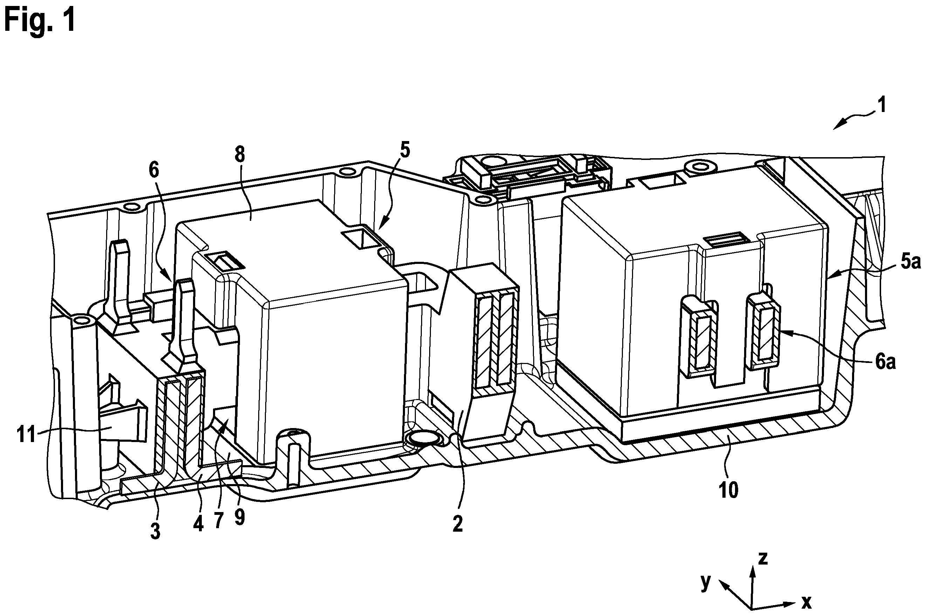

Fig. 1 ist eine perspektivische Schnittdarstellung eines Ausführungsbeispiels einer Vorrichtung 1.

Die Vorrichtung 1 umfasst eine Stromschienenanordnung 2 mit zwei Stromschienen 3, 4 und eine Filteranordnung 5. Die Filteranordnung 5 umfasst eine in einem Filterabschnitt 6 der Stromschienenanordnung angeordnete Filtervorrichtung 7 und eine Abdeckung 8, welche die Filtervorrichtung 7 abdeckt. Daneben umfasst die Filteranordnung 5 ein Rückstellelement 9.

Ferner umfasst die Vorrichtung 1 im vorliegenden Ausführungsbeispiel eine weitere Filteranordnung 5a für einen weiteren Filterabschnitt 6a der Stromschienenanordnung 2. Die Filteranordnungen 5, 5a sind identisch, sodass sich alle Ausführungen zur Filteranordnung 5 auf die weitere Filteranordnung 5a übertragen lassen.

Die Vorrichtung 1 umfasst daneben ein Bodenelement 10, an dem Befestigungselemente 11 der Stromschienenanordnung 2 durch Befestigungsmittel (nicht gezeigt), beispielsweise Schrauben, befestigt sind, wobei in Fig. 1 lediglich ein Befestigungselement 11 sichtbar ist. Die Filteranordnungen 5, 5a liegen in muldenartigen Abschnitten des Bodenelements 10 auf diesem auf.

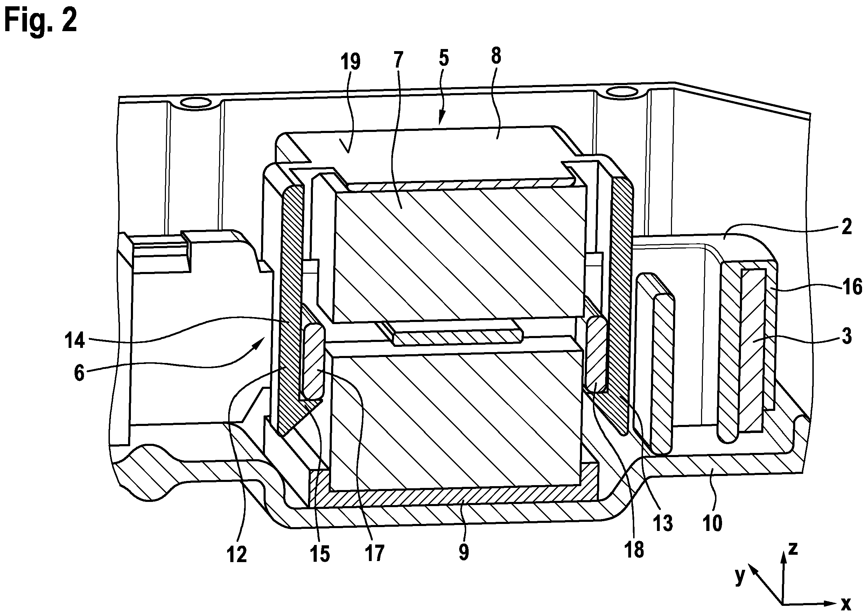

Fig. 2 ist eine weitere perspektivische Schnittdarstellung der Vorrichtung 1 im Filterabschnitt 6 der Stromschienenanordnung 2. Die Schnittebene von Fig. 2 verläuft parallel zu jener in Fig. 1 zwischen den Stromschienen 3, 4.

Die Abdeckung 8 umfasst eine Fixiervorrichtung mit zwei Fixierelementen 12, 13 und ist dazu eingerichtet, die Stromschienenanordnung 2 zum Befestigen der Abdeckung an dieser zu hintergreifen. Die Fixierelemente 12, 13 weisen dazu jeweils einen elastisch verformbaren Schenkelabschnitt 14 und an einem freien Ende des Schenkelabschnitts 14 ein die Stromschienenanordnung hintergreifendes Hakenelement 15 auf.

Die Stromschienenanordnung 2 umfasst eine elektrische isolierende Ummantelung 16 auf, die die Stromschienen 3, 4 im Filterabschnitt 6 vollständig umgibt, und an beiden Enden des Filterabschnitts 6 jeweils einen materialeinheitlich und einstückig mit der Ummantelung ausgebildeten Steg 17, 18 der Stromschienenanordnung 2. Die Fixiervorrichtung bzw. die Fixierelemente 13, 14 hintergreifen dabei die Stege 17, 18 von einer der Filtervorrichtung 7 abgewandten Seite aus. Dabei werden die Schenkelabschnitte 14 elastisch nach außen verformt bis das Hakenelement 15 ein bodenelementseitiges Ende des Stegs 17, 18 erreicht und den Steg 17, 18 hintergreifend einschnappt.

Die Stege 17, 18 erstrecken sich zwischen den Stromschienen 3, 4 senkrecht zu deren inneren Langseiten. Die Stege 17, 18 selbst weisen einen im Wesentlichen rechteckigen Querschnitt auf, wobei sich die Kurzseiten entlang einer Richtung von dem einen Ende des Filterabschnitts 6 zu seinem anderen Ende erstrecken.

Das Rückstellelement 9 ist als flacher, plattenartiger Formkörper aus einem aufgeschäumten Material gebildet und stellt bei einer elastischen Verformung Rückstellkräfte bereit.

Das Rückstellelement 9 realisiert die Funktion eines ersten Rückstellmittels, welches eine die Fixiervorrichtung an die Stromschienenanordnung 2 pressende Rückstellkraft auf die Abdeckung 8 ausübt. Wie in Fig. 1 zu erkennen ist, liegt dazu ein einer Deckelfläche 19 der Abdeckung 8 gegenüberliegender bodenelementseitiger Rand der Abdeckung 8 auf dem Rückstellelement 9 auf und verformt dieses elastisch. Als erstes Rückstellmittel kann insofern ein äußerer Randbereich des Rückstellelements 9 aufgefasst werden. Durch das erste Rückstellmittel wird die Abdeckung 8 in einer z-Richtung kraftschlüssig an der Stromschienenanordnung 2 fixiert.

Das Rückstellelement 9 realisiert darüber hinaus die Funktion eines zweiten Rückstellmittels zwischen dem Bodenelement 10 und der Filtervorrichtung 7, wobei das zweite Rückstellmittel eine Rückstellkraft auf die Filtervorrichtung 7 ausübt. Dazu liegt die Filtervorrichtung 7 auf dem Rückstellelement 9 auf und verformt dieses elastisch. Ein vom äußeren Randbereich, der das erste Rückstellmittel realisiert, umgebener Innenbereich des Rückstellelements 9 kann somit als zweites Rückstellmittel aufgefasst werden. Durch das zweite Rückstellmittel wird die Filtervorrichtung 7 gegen die Deckelfläche 19 der Abdeckung 8 gepresst, sodass über die Deckelfläche 19 eine kraftschlüssige Fixierung der Filtervorrichtung 7 an der Stromschienenanordnung 2 in z-Richtung realisiert ist.

Das Rückstellelement 9 bzw. die dadurch realisierten Rückstellmittel sind darüber hinaus derart ausgebildet, dass sie ein Verrutschen der Filtervorrichtung 7 und der Abdeckung 8 gegenüber dem Bodenelement 10 verhindern bzw. hemmen. Zusammen mit den die Stege 17, 18 hintergreifenden Fixierelementen 12, 13 wird so auch eine Fixierung der Filtervorrichtung 7 in x- und y-Richtung an der Stromschienenanordnung 2 realisiert. Um das Verrutschen zu verhindern bzw. zu hemmen, sind eine Haftreibungzahl einer abdeckungs- und filtervorrichtungsseitigen Oberfläche des Rückstellelements 9 bezüglich des Materials der Abdeckung 8 bzw. der Filtervorrichtung 7 und eine Haftreibungszahl einer bodenelementseitigen Oberfläche des Rückstellelements 9 bezüglich des Materials des Bodenelements 10 größer als auf das Material des Bodenelements 10 bezogene Haftreibungszahlen bezüglich des Materials der Abdeckung 8 und der Filtervorrichtung 7 gewählt.

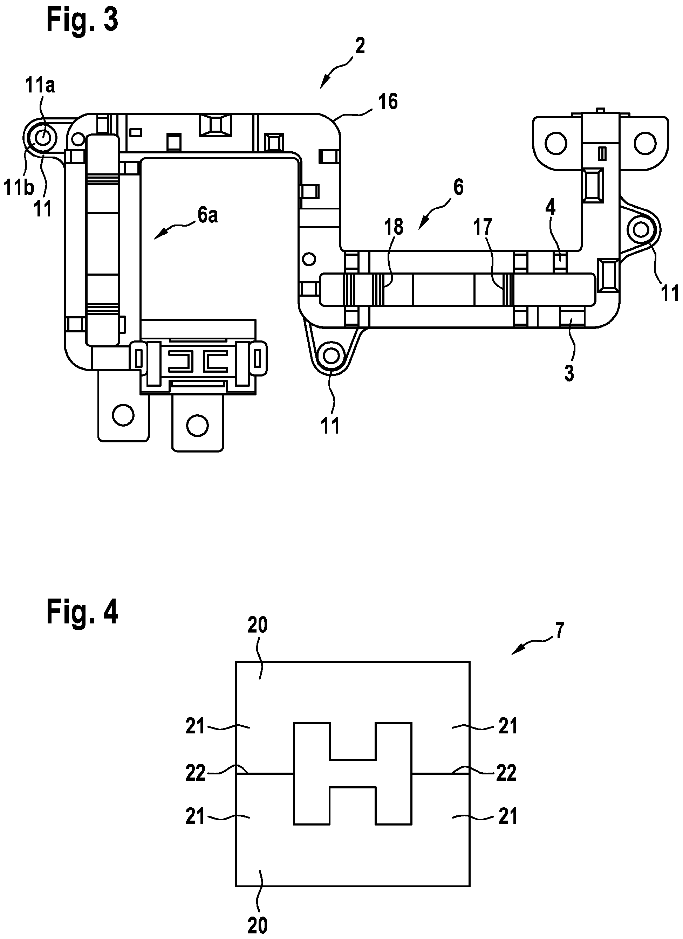

Fig. 3 ist eine Draufsicht auf die Stromschienenanordnung 2 und zeigt insbesondere die Positionen der Filterabschnitte 6, 6a und der an ihren Enden ausgebildeten Stege 17, 18. Ersichtlich ist die Ummantelung 16 in den Filterabschnitten 6, 6a durchgängig ausgebildet, wohingegen die Ummantelung 16 außerhalb der Filterabschnitte 6, 6a einige die Stromschienen 3, 4 freilegende Ausnehmung aufweist. Fig. 3 zeigt auch die Position von insgesamt drei Befestigungsmitteln 11, die als Vorsprünge an die Ummantelung 16 angeformt sind und jeweils eine Durchgangsöffnung 11a sowie einer darin angeordnete und in die Ummantelung 16 integrierte Einpressbuchse 11b mit einem Gewinde zum Durchführen des Befestigungsmittels (nicht gezeigt) aufweisen.

Fig. 4 ist eine Prinzipskizze der Filtervorrichtung 7. Diese ist aus zwei E-förmigen Körpern 20 aus einem Ferritmaterial gebildet. Äußere Schenkel 21 der Körper sind durch Klebeschichten 22 paarweise aneinander befestigt.

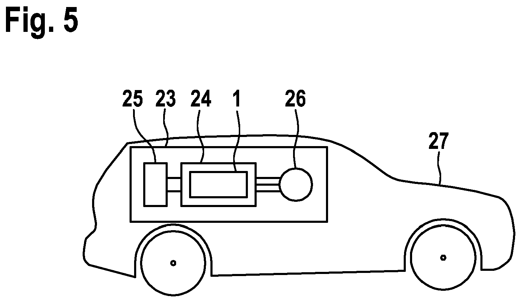

Fig. 5 ist eine Prinzipskizze eines Ausführungsbeispiels einer Antriebseinrichtung 23 mit einem Ausführungsbeispiel eines Stromrichters 24.

Der Stromrichter 24 weist eine Vorrichtung 1 nach dem zuvor beschriebenen Ausführungsbeispiel auf, wobei die Stromschienen 3, 4 eine elektrisch leitende Verbindung zwischen einer Batterie 25 und einer Leistungseinheit (nicht gezeigt) des Stromrichters 23 realisieren. Das Bodenelement 10 realisiert einen Gehäuseabschnitt des Stromrichters 24. Die Antriebseinrichtung 23 umfasst ferner eine elektrische Maschine 26 zum Antreiben eines Fahrzeugs 27, welche vom Stromrichter 24 elektrisch versorgt wird.

Gemäß einem Ausführungsbeispiel eines Herstellungsverfahrens einer Vorrichtung 1 wird zunächst eine Stromschienenanordnung 2 mit zwei Stromschienen 3, 4 bereitgestellt. Anschließend werden zwei E-förmige Körper aus einem Ferritmaterial bereitgestellt und zum Anbringen einer Filtervorrichtung 7 von gegenüberliegenden Seiten auf die Stromschienenanordnung 2 gesetzt und an ihren äußeren Schenkeln verklebt. Es werden sodann ein Bodenelement 10 und ein Rückstellelement 9 bereitgestellt, wobei das Rückstellelement 9 auf dem Bodenelement 10 angeordnet wird. Die Stromschienenanordnung 2 wird dann derart auf dem Bodenelement 10 angeordnet, dass die Filtervorrichtung 7 auf dem Rückstellelement 9 aufliegt, und am Bodenelement 10 befestigt. Anschließend wird eine Abdeckung 8 für die Filtervorrichtung 7 bereitgestellt und derart an der Stromschienenanordnung 2 fixiert, dass eine Fixiervorrichtung der Abdeckung die Stromschienenanordnung 2 hintergreift. Dabei verformen sich Fixierelemente 12, 13 der Abdeckung elastisch und hintergreifen Stege 17, 18 der Stromschienenanordnung 2 durch Einschnappen. Ferner verformt die Abdeckung 8 das Rückstellelement 9 elastisch, sodass diese eine Rückstellkraft auf die Abdeckung 8 ausübt.

Im Übrigen lassen sich alle Ausführungen zu den Ausführungsbeispielen der Vorrichtung 1 auf das Herstellungsverfahren übertragen.

## Patentansprüche

1. Vorrichtung (1) mit
- einer zwei Stromschienen (3, 4) aufweisenden Stromschienenanordnung (2) und
- einer Filteranordnung (5), umfassend eine Filtervorrichtung (7), welche die Stromschienen (3, 4) in einem Filterabschnitt (6) umgibt, und eine die Filtervorrichtung (7) abdeckende Abdeckung (8),wobei
die Abdeckung eine Fixiervorrichtung aufweist, welche dazu eingerichtet ist, die Stromschienenanordnung (2) zum Befestigen der Abdeckung (8) an der Stromschienenanordnung (2) zu hintergreifen,
**dadurch gekennzeichnet, dass**
die Fixiervorrichtung mehrere Fixierelemente (12, 13) aufweist, welche beim Aufsetzen der Abdeckung elastisch verformbar sind, um die Stromschienenanordnung (2) durch Einschnappen zu hintergreifen.

2. Vorrichtung nach Anspruch 1, wobei
die Stromschienenanordnung (2) an beiden Enden des Filterabschnitts (6) jeweils einen elektrisch isolierenden Steg (17, 18) aufweist, welchen die Fixiervorrichtung hintergreift.

3. Vorrichtung nach Anspruch 2, wobei
die Stromschienen (3, 4) jeweils im Querschnitt Langseiten und Kurzseiten aufweisen, wobei sich der Steg (17, 18) senkrecht zu einer jeweiligen inneren Langseite der Stromschienen (3, 4) erstreckt und/oder
wobei der Steg (17, 18) im Querschnitt Langseiten und Kurzseiten aufweist, wobei sich die Kurzseiten entlang einer Richtung von einem Ende des Filterabschnitts (6), zum anderen Ende des Filterabschnitts (6) erstrecken.

4. Vorrichtung nach Anspruch 2 oder 3, wobei
die Stromschienenanordnung (2) zumindest entlang des Filterabschnitts eine die Stromschienen (3, 4) umgebende elektrisch isolierende Ummantelung (16) aufweist, wobei der Steg (17, 18) und die Ummantelung (16) einstückig und/oder materialeinheitlich ausgebildet sind.

5. Vorrichtung nach einem der vorhergehenden Ansprüche, ferner umfassend ein Bodenelement (10), an dem die Stromschienenanordnung (2) befestigt ist.

6. Vorrichtung nach Anspruch 5, wobei
die Filteranordnung (5) ein zwischen dem Bodenelement (10) und der Abdeckung (8) angeordnetes erstes Rückstellmittel aufweist, welches eine die Fixiervorrichtung an die Stromschienenanordnung (2) pressende Rückstellkraft auf die Abdeckung (8) ausübt.

7. Vorrichtung nach Anspruch 6, wobei
eine Haftreibungzahl einer abdeckungsseitigen Oberfläche des ersten Rückstellmittels bezüglich des Materials der Abdeckung (8) und eine Haftreibungszahl einer bodenelementseitigen Oberfläche des ersten Rückstellmittels bezüglich des Materials des Bodenelements (10) größer als eine Haftreibungszahl bezüglich des Materials der Abdeckung (8) und des Materials des Bodenelements (10) sind.

8. Vorrichtung nach einem der Ansprüche 5 bis 7, wobei
die Filteranordnung ein zweites Rückstellmittel zwischen dem Bodenelement (10) und einer Deckelfläche (19) der Abdeckung (8) aufweist, wobei das zweite Rückstellmittel eine Rückstellkraft auf die Filtervorrichtung (7) ausübt.

9. Vorrichtung nach Anspruch 8, wobei
eine Haftreibungzahl einer filtervorrichtungsseitigen Oberfläche des zweiten Rückstellmittels bezüglich des Materials der Filtervorrichtung (7) und eine Haftreibungszahl einer bodenelement- oder deckelflächenseitigen Oberfläche des zweiten Rückstellmittels bezüglich des Materials des Bodenelements (10) oder der Deckelfläche (19) größer als eine Haftreibungszahl bezüglich des Materials der Filtervorrichtung (7) und des Materials des Bodenelements (10) oder der Deckelfläche (19) sind.

10. Vorrichtung nach den Ansprüchen 6 oder 7 und den Ansprüchen 8 oder 9, wobei das erste Rückstellmittel und das zweite Rückstellmittel durch ein einteiliges Rückstellelement (9) ausgebildet sind, das zwischen der Filtervorrichtung (7) und der Abdeckung (8) einerseits und dem Bodenelement (10) andererseits angeordnet ist.

11. Vorrichtung nach einem der Ansprüche 6 bis 10, wobei
das erste Rückstellmittel und/oder das zweite Rückstellmittel und/oder das Rückstellelement als flacher Formkörper ausgebildet ist oder sind, und/oder das erste Rückstellmittel und/oder das zweite Rückstellmittel und/oder das Rückstellelement aus einem aufgeschäumten Material gebildet ist oder sind.

12. Herstellungsverfahren, umfassend folgende Schritte:
- Bereitstellen einer Stromschienenanordnung (2) mit zwei Stromschienen (3, 4)
- Anbringen einer Filtervorrichtung (7) in einem Filterabschnitt (6) der Stromschienenanordnung (2), so dass die Filtervorrichtung (7) die Stromschienen (3, 4) umgibt;
- Bereitstellen einer Abdeckung (8) für die Filtervorrichtung (7); und
- Fixieren der Abdeckung (8) an der Stromschienenanordnung (2) derart, eine Fixiervorrichtung der Abdeckung (8) die Stromschienenanordnung (2) hintergreift.

13. Stromrichter (24), umfassend eine Vorrichtung (1) nach einem der Ansprüche 1 bis 11 oder eine durch ein Herstellungsverfahren nach Anspruch 12 erhaltene Vorrichtung (1), wobei die Stromschienen (3, 4) elektrisch leitend mit einer Leistungseinheit des Stromrichters (24) verbunden sind.

14. Antriebseinrichtung (23) zum Antreiben eines Fahrzeugs (27), umfassend einen Stromrichter (24) nach Anspruch 13 und eine durch den Stromrichter (24) versorgbare elektrische Maschine (26).

## Claims

1. Apparatus (1), comprising:
- a busbar arrangement (2) having two busbars (3, 4), and
- a filter arrangement (5), comprising a filter device (7) which surrounds the busbars (3, 4) in a filter section (6), and a cover (8) covering the filter device (7),
wherein the cover has a fixing device which is configured to engage behind the busbar arrangement (2) for fastening the cover (8) to the busbar arrangement (2), **characterized in that** the fixing device has a plurality of fixing elements (12, 13) which are elastically deformable when the cover is placed on, in order to engage behind the busbar arrangement (2) by snapping.

2. Apparatus according to Claim 1, wherein the busbar arrangement (2) has at both ends of the filter section (6) a respective electrically insulating web (17, 18), which the fixing device engages behind.

3. Apparatus according to Claim 2, wherein the busbars (3, 4) each have, in cross-section, long sides and short sides, wherein the web (17, 18) extends perpendicularly to a respective inner long side of the busbars (3, 4), and/or wherein the web (17, 18) has, in cross-section, long sides and short sides, wherein the short sides extend along a direction from one end of the filter section (6) to the other end of the filter section (6).

4. Apparatus according to Claim 2 or 3, wherein the busbar arrangement (2) has, at least along the filter section, an electrically insulating sheath (16) surrounding the busbars (3, 4), wherein the web (17, 18) and the sheath (16) are formed in one piece and/or of the same material.

5. Apparatus according to one of the preceding claims, further comprising a base element (10) to which the busbar arrangement (2) is fastened.

6. Apparatus according to Claim 5, wherein the filter arrangement (5) has a first resilient means arranged between the base element (10) and the cover (8), which exerts a restoring force on the cover (8), pressing the fixing device against the busbar arrangement (2).

7. Apparatus according to Claim 6, wherein a coefficient of static friction of a cover-side surface of the first resilient means with respect to the material of the cover (8) and a coefficient of static friction of a base-element-side surface of the first resilient means with respect to the material of the base element (10) are greater than a coefficient of static friction with respect to the material of the cover (8) and the material of the base element (10).

8. Apparatus according to one of Claims 5 to 7, wherein the filter arrangement has a second resilient means between the base element (10) and a top surface (19) of the cover (8), wherein the second resilient means exerts a restoring force on the filter device (7).

9. Apparatus according to Claim 8, wherein a coefficient of static friction of a filter-device-side surface of the second resilient means with respect to the material of the filter device (7) and a coefficient of static friction of a base-element-side or top-surface-side surface of the second resilient means with respect to the material of the base element (10) or the top surface (19) are greater than a coefficient of static friction with respect to the material of the filter device (7) and the material of the base element (10) or the top surface (19).

10. Apparatus according to Claims 6 or 7 and Claims 8 or 9, wherein the first resilient means and the second resilient means are formed by a one-piece resilient element (9) which is arranged between the filter device (7) and the cover (8) on the one hand and the base element (10) on the other hand.

11. Apparatus according to one of Claims 6 to 10, wherein the first resilient means and/or the second resilient means and/or the resilient element is or are designed as a flat shaped body, and/or the first resilient means and/or the second resilient means and/or the resilient element is or are formed from a foamed material.

12. Method of manufacturing, comprising the following steps:
- Providing a busbar arrangement (2) with two busbars (3, 4);
- Attaching a filter device (7) in a filter section (6) of the busbar arrangement (2) such that the filter device (7) surrounds the busbars (3, 4);
- Providing a cover (8) for the filter device (7); and
- Fixing the cover (8) to the busbar arrangement (2) in such a way that a fixing device of the cover (8) engages behind the busbar arrangement (2).

13. Power converter (24), comprising an apparatus (1) according to one of Claims 1 to **11** or an apparatus (1) obtained by a manufacturing method according to Claim 12, wherein the busbars (3, 4) are electrically conductively connected to a power unit of the power converter (24).

14. Drive device (23) for driving a vehicle (27), comprising a power converter (24) according to Claim 13 and an electric machine (26) that can be supplied by the power converter (24)

## Revendications

1. Dispositif (1), comprenant :
- un agencement de barres omnibus (2) présentant deux barres omnibus (3, 4), et
- un agencement de filtre (5), comprenant un dispositif de filtre (7) qui entoure les barres omnibus (3, 4) dans une section de filtre (6), et un couvercle (8) recouvrant le dispositif de filtre (7), dans lequel le couvercle présente un dispositif de fixation qui est conçu pour s'engager derrière l'agencement de barres omnibus (2) pour fixer le couvercle (8) à l'agencement de barres omnibus (2), **caractérisé en ce que** le dispositif de fixation présente plusieurs éléments de fixation (12, 13) qui sont déformables élastiquement lors de la mise en place du couvercle, afin de s'engager derrière l'agencement de barres omnibus (2) par encliquetage.

2. Dispositif selon la revendication 1, dans lequel l'agencement de barres omnibus (2) présente, aux deux extrémités de la section de filtre (6), une nervure électriquement isolante respective (17, 18), derrière laquelle le dispositif de fixation s'engage.

3. Dispositif selon la revendication 2, dans lequel les barres omnibus (3, 4) présentent chacune, en section transversale, des côtés longs et des côtés courts, la nervure (17, 18) s'étendant perpendiculairement à un côté long intérieur respectif des barres omnibus (3, 4), et/ou la nervure (17, 18) présente, en section transversale, des côtés longs et des côtés courts, les côtés courts s'étendant le long d'une direction d'une extrémité de la section de filtre (6) à l'autre extrémité de la section de filtre (6).

4. Dispositif selon la revendication 2 ou 3, dans lequel l'agencement de barres omnibus (2) présente, au moins le long de la section de filtre, une gaine électriquement isolante (16) entourant les barres omnibus (3, 4), la nervure (17, 18) et la gaine (16) étant formées d'une seule pièce et/ou d'un seul matériau.

5. Dispositif selon l'une des revendications précédentes, comprenant en outre un élément de base (10) auquel l'agencement de barres omnibus (2) est fixé.

6. Dispositif selon la revendication 5, dans lequel l'agencement de filtre (5) présente un premier moyen de rappel disposé entre l'élément de base (10) et le couvercle (8), qui exerce sur le couvercle (8) une force de rappel pressant le dispositif de fixation contre l'agencement de barres omnibus (2).

7. Dispositif selon la revendication 6, dans lequel un coefficient de frottement statique d'une surface du premier moyen de rappel côté couvercle par rapport au matériau du couvercle (8) et un coefficient de frottement statique d'une surface du premier moyen de rappel côté élément de base par rapport au matériau de l'élément de base (10) sont supérieurs à un coefficient de frottement statique par rapport au matériau du couvercle (8) et au matériau de l'élément de base (10).

8. Dispositif selon l'une des revendications 5 à 7, dans lequel l'agencement de filtre présente un second moyen de rappel entre l'élément de base (10) et une surface de couvercle (19) du couvercle (8), le second moyen de rappel exerçant une force de rappel sur le dispositif de filtre (7).

9. Dispositif selon la revendication 8, dans lequel un coefficient de frottement statique d'une surface du second moyen de rappel côté dispositif de filtre par rapport au matériau du dispositif de filtre (7) et un coefficient de frottement statique d'une surface du second moyen de rappel côté élément de base ou côté surface de couvercle par rapport au matériau de l'élément de base (10) ou de la surface de couvercle (19) sont supérieurs à un coefficient de frottement statique par rapport au matériau du dispositif de filtre (7) et au matériau de l'élément de base (10) ou de la surface de couvercle (19).

10. Dispositif selon les revendications 6 ou 7 et les revendications 8 ou 9, dans lequel le premier moyen de rappel et le second moyen de rappel sont formés par un élément de rappel d'une seule pièce (9) qui est disposé entre le dispositif de filtre (7) et le couvercle (8) d'une part et l'élément de base (10) d'autre part.

11. Dispositif selon l'une des revendications 6 à 10, dans lequel le premier moyen de rappel et/ou le second moyen de rappel et/ou l'élément de rappel est ou sont conçu(s) comme un corps façonné plat, et/ou le premier moyen de rappel et/ou le second moyen de rappel et/ou l'élément de rappel est ou sont formé(s) d'un matériau en mousse.

12. Procédé de fabrication, comprenant les étapes suivantes :
- Fourniture d'un agencement de barres omnibus (2) avec deux barres omnibus (3, 4) ;
- Montage d'un dispositif de filtre (7) dans une section de filtre (6) de l'agencement de barres omnibus (2) de sorte que le dispositif de filtre (7) entoure les barres omnibus (3, 4) ;
- Fourniture d'un couvercle (8) pour le dispositif de filtre (7) ; et
- Fixation du couvercle (8) à l'agencement de barres omnibus (2) de telle manière qu'un dispositif de fixation du couvercle (8) s'engage derrière l'agencement de barres omnibus (2).

13. Convertisseur de courant (24), comprenant un dispositif (1) selon l'une des revendications 1 à **11** ou un dispositif (1) obtenu par un procédé de fabrication selon la revendication 12, dans lequel les barres omnibus (3, 4) sont connectées de manière électriquement conductrice à une unité de puissance du convertisseur de courant (24).

14. Dispositif d'entraînement (23) pour entraîner un véhicule (27), comprenant un convertisseur de courant (24) selon la revendication 13 et une machine électrique (26) pouvant être alimentée par le convertisseur de courant (24).
